(19) **Europäisches Patentamt European Patent Office Office européen des brevets**

(11) **EP 3 561 812 B1**

(12) **FASCICULE DE BREVET EUROPEEN**

(45) Date de publication et mention de la délivrance du brevet:
**17.03.2021 Bulletin 2021/11**

(51) Int Cl.:
***G11C 13/00*** *(2006.01)*

(21) Numéro de dépôt: **19170990.6**

(22) Date de dépôt: **25.04.2019**

(54) **PROCÉDÉ DE PROGRAMMATION D'UNE MEMOIRE RESISTIVE**

PROGRAMMIERVERFAHREN EINES RESISTIVEN SPEICHERS

METHOD FOR PROGRAMMING A RESISTIVE MEMORY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.04.2018 FR 1853710**

(43) Date de publication de la demande:
**30.10.2019 Bulletin 2019/44**

(73) Titulaire: **Commissariat à l'Energie Atomique et aux Energies Alternatives 75015 Paris (FR)**

(72) Inventeurs:
• **GROSSI, Alessandro 38054 GRENOBLE CEDEX 09 (FR)**
• **VIANELLO, Elisa 38054 GRENOBLE CEDEX 09 (FR)**

(74) Mandataire: **Lebkiri, Alexandre Cabinet Camus Lebkiri 25, Rue de Maubeuge 75009 Paris (FR)**

(56) Documents cités:
**US-A1- 2013 258 753      US-A1- 2014 226 388
US-A1- 2014 245 108**

EP 3 561 812 B1

**Description**

DOMAINE TECHNIQUE DE L'INVENTION

La présente invention est relative au domaine des mémoires résistives, également appelées « RRAM » pour « Resistive Random-Access Memory » selon la terminologie anglo-saxonne. La présente invention concerne plus particulièrement un procédé de programmation d'une telle mémoire résistive.

ARRIÈRE-PLAN TECHNOLOGIQUE DE L'INVENTION

Les mémoires résistives sont des mémoires non-volatiles présentant une vitesse de fonctionnement élevée, une faible consommation d'énergie électrique et une grande durée de vie. Pour ces raisons, les mémoires résistives sont des candidates prometteuses pour remplacer à la fois les mémoires vives et les mémoires non-volatiles actuelles telles que les mémoires de type flash.

Il existe plusieurs technologies de mémoires résistives. On peut notamment citer les mémoires résistives à pont conducteur, également appelées « CBRAM » pour « Conductive-Bridging Random-Access Memory » selon la terminologie anglo-saxonne, ou les mémoires résistives à base d'oxyde, également appelées « OxRAM » pour « Oxide-based Random-Access Memory » selon la terminologie anglo-saxonne.

Une mémoire résistive est composée d'une multitude de cellules mémoires résistives agencées en lignes et colonnes de manière à former une matrice. La cellule mémoire comporte un matériau diélectrique disposé entre deux électrodes conductrices. Le matériau diélectrique est capable de basculer de manière réversible entre un état fortement résistif et un état faiblement résistif, respectivement appelés « High-Resistance State » et « Low-Resistance State » selon la terminologie anglo-saxonne. Ces deux états de résistance permettent donc de stocker un bit d'information dans chaque cellule mémoire.

Le changement d'état de résistance est lié à la formation et à la rupture, dans le matériau diélectrique, d'une zone de commutation, également appelée « switching zone » en anglais, qui forme un chemin conducteur électriquement reliant les électrodes de la cellule mémoire. La nature de ce chemin conducteur dépend de la technologie utilisée. Par exemple, dans les mémoires de type CBRAM, le chemin conducteur est un filament formé par des ions métalliques, et dans les mémoires de type OxRAM, la formation du chemin conducteur est attribuée à l'accumulation de lacunes d'oxygène au sein de la couche d'oxyde.

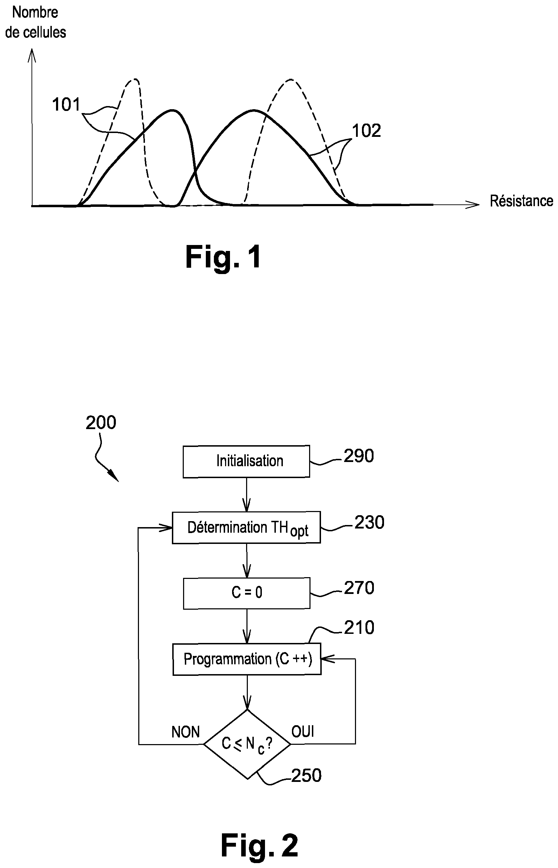

En tout état de cause, les mécanismes de conduction qui interviennent dans les cellules mémoires résistives impliquent une grande variabilité des valeurs de résistance que peuvent prendre les cellules mémoires. La figure 1 représente de manière schématique des distributions de valeurs de résistance d'une cellule mémoire résistive dans l'état faiblement résistif 101 et dans l'état fortement résistif 102. La figure 1 montre également l'influence du vieillissement de la cellule mémoire sur ces distributions. Initialement, les distributions des valeurs de résistance (représentées en traits pointillés) sont espacées l'une de l'autre. Avec le vieillissement de la cellule mémoire, les distributions des valeurs de résistance (représentées en traits continus) ont tendance à s'élargir et à se rapprocher l'une de l'autre, ce qui peut conduire à l'apparition d'une zone de recouvrement.

Par ailleurs, pour programmer une cellule mémoire, une tension de programmation est appliquée entre les électrodes de la cellule mémoire. Il peut s'agir d'une tension d'écriture pour écrire la cellule mémoire, c'est-à-dire la placer dans l'état faiblement résistif, ou d'une tension d'effacement pour effacer la cellule mémoire, c'est-à-dire la placer dans l'état fortement résistif.

Cependant, après une telle opération de programmation, il peut arriver que la cellule mémoire ne passe pas dans l'état de résistance souhaité. Pour cette raison, on vérifie que la cellule mémoire est correctement programmée en comparant sa valeur de résistance à un seuil de résistance prédéfini. Si le résultat de cette comparaison est négatif, cela signifie que l'opération de programmation n'a pas fonctionné. Dans ce cas, l'opération de programmation est répétée un certain nombre de fois jusqu'à ce que la cellule mémoire prenne l'état de résistance souhaité ou jusqu'à ce qu'un nombre maximal de tentatives soit atteint.

En général, on définit un premier seuil de résistance utilisé pour lire la cellule mémoire, un deuxième seuil de résistance utilisé lorsque la cellule mémoire est programmée en écriture et un troisième seuil de résistance utilisé lorsque la cellule mémoire est programmée en effacement. Le troisième seuil de résistance est supérieur au deuxième seuil de résistance et leur différence définit la fenêtre de programmation de la cellule mémoire. Le premier seuil de résistance peut alors être choisi au milieu de la fenêtre de programmation.

Un inconvénient de cette méthode de programmation est que les différents seuils de résistance sont fixes tout au long de la durée de vie de la mémoire résistive alors que les distributions des valeurs de résistance s'élargissent. Par conséquent, avec le vieillissement de la mémoire, la programmation des cellules mémoires échoue de plus en plus souvent, ce qui augmente le nombre de tentatives nécessaires pour réussir à placer les cellules mémoires dans l'état de résistance désiré. Il en résulte une augmentation du temps de programmation de la mémoire résistive.

Le document US2013/258753 décrit le principe d'ajuster le seuil de résistance utilisé pour la lecture d'une mémoire résistive CBRAM afin de s'adapter à l'élargissement des distributions des valeurs de résistance que peuvent prendre les cellules mémoires.

## RÉSUMÉ DE L'INVENTION

Il ressort de ce qui précède qu'il existe un besoin d'améliorer la programmation d'une mémoire résistive en définissant un seuil de résistance qui varie au cours de la durée de vie de la mémoire résistive afin de minimiser les erreurs de programmation.

La présente invention vise à répondre à ce besoin en proposant un procédé de programmation d'une mémoire résistive non volatile comprenant une pluralité de cellules mémoires résistives non volatiles, chaque cellule mémoire étant apte à commuter de manière réversible entre :

- un premier état de programmation, dit « état faiblement résistif », dans lequel la cellule mémoire a une valeur de résistance électrique inférieure à un premier seuil de résistance ; et
- un deuxième état de programmation, dit « état fortement résistif », dans lequel la cellule mémoire a une valeur de résistance électrique supérieure au premier seuil de résistance ;

le procédé de programmation comportant une étape de détermination du premier seuil de résistance effectuée périodiquement, l'étape de détermination comprenant :

- une première étape d'écriture destinée à placer un premier groupe de cellules mémoires dans l'état faiblement résistif, un premier nombre de cellules mémoires du premier groupe n'étant pas effectivement placées dans l'état faiblement résistif après la première étape de programmation ; et
- une deuxième étape d'effacement destinée à placer un deuxième groupe de cellules mémoires dans l'état fortement résistif, un deuxième nombre de cellules mémoires du deuxième groupe n'étant pas effectivement placées dans l'état fortement résistif après la deuxième étape de programmation ;

le premier seuil de résistance étant déterminé de manière à minimiser un nombre d'erreurs de programmation égal à la somme du premier nombre de cellules mémoires et du deuxième nombre de cellules mémoires.

Grâce à l'invention, le premier seuil de résistance est adapté régulièrement en fonction du vieillissement de la mémoire résistive ce qui permet de réduire le taux d'erreur provoquer par l'élargissement des distributions des valeurs de résistance que peuvent prendre les cellules mémoires. Le nombre de tentatives nécessaires pour placer une cellule mémoire dans un état de résistance donné est également réduit ce qui conduit à une diminution du temps de programmation.

Le procédé selon l'invention peut également comporter une ou plusieurs caractéristiques parmi les suivantes considérées individuellement ou selon toutes les combinaisons techniquement possibles.

Selon un mode de mise en œuvre, l'étape de détermination du premier seuil de résistance comporte les étapes suivantes :

a) définir un seuil de résistance variable égal au premier seuil de résistance déterminé au cours de la précédente étape de détermination ;

b) effectuer la première étape d'écriture et la deuxième étape d'effacement en utilisant le seuil de résistance variable ;

c) déterminer le nombre d'erreurs de programmation survenues au cours de l'étape b) ;

d) répéter les étapes b) et c) après avoir modifié le seuil de résistance variable selon un sens de variation prédéterminé, les étapes b) et c) étant répétées au moins une fois et tant que le nombre d'erreurs de programmation diminue entre deux étapes b) consécutives ;

e) définir le premier seuil de résistance égal au seuil de résistance variable utilisé au cours de l'avant-dernière étape b).

Selon un mode de mise en œuvre, deux étapes consécutives de détermination du premier seuil de résistance sont séparées par un intervalle de temps correspondant à un premier nombre prédéterminé de cycles de programmation qu'au moins une cellule mémoire a subi.

Selon un mode de mise en œuvre, le procédé de programmation comporte une étape de programmation comprenant au moins l'une des étapes suivantes :

- une étape d'écriture destinée à placer au moins une cellule mémoire dans l'état faiblement résistif, ladite au moins une cellule mémoire étant considérée comme étant dans l'état faiblement résistif au terme de l'étape d'écriture si la valeur de résistance de ladite au moins une cellule mémoire est inférieure à un deuxième seuil de résistance inférieur ou égal au premier seuil de résistance ;
- une étape d'effacement destinée à placer au moins une cellule mémoire dans l'état fortement résistif, ladite au moins une cellule mémoire étant considérée comme étant dans l'état fortement résistif au terme de l'étape d'effacement si la valeur de résistance de ladite au moins une cellule mémoire est supérieure à un troisième seuil de résistance supérieur ou égal au premier seuil de résistance ;

le deuxième seuil de résistance et le troisième seuil de résistance étant définis en fonction du premier seuil de résistance déterminé.

Selon un mode de mise en œuvre, le deuxième seuil de résistance et le troisième seuil de résistance sont égaux au premier seuil de résistance.

Selon un mode de mise en œuvre, que le deuxième seuil de résistance et le troisième seuil de résistance sont respectivement égaux à 90 % et à 110 % du premier seuil de résistance.

Selon un mode de mise en œuvre, chaque cellule mémoire comporte un matériau diélectrique disposé entre deux électrodes, la cellule mémoire passant de l'état fortement résistif à l'état faiblement résistif lorsqu'une zone de commutation est formée dans le matériau diélectrique, la zone de commutation reliant électriquement les électrodes de la cellule mémoire, le procédé de programmation comportant en outre une étape d'initialisation de la mémoire résistive comprenant les étapes suivantes :

- former pour la première fois la zone de commutation de chaque cellule mémoire ; et
- conditionner les cellules mémoires en répétant un deuxième nombre prédéterminé de cycles de programmation comprenant chacun une opération d'écriture et une opération d'effacement des cellules mémoires.

Selon un mode de mise en œuvre, les cellules mémoires sont de type CBRAM ou OxRAM.

**BRÈVE DESCRIPTION DES FIGURES**

L'invention et ses différentes applications seront mieux comprises à la lecture de la description qui suit et à l'examen des figures qui l'accompagnent, parmi lesquelles :

- la figure 1 représente des distributions d'une cellule mémoire résistive dans l'état faiblement résistif et dans l'état fortement résistif ;
- la figure 2 est un logigramme d'un mode de mise en œuvre du procédé de programmation selon l'invention ;
- le figure 3A est un logigramme d'une étape d'écriture du procédé de programmation de la figure 2 ;
- le figure 3B est un logigramme d'une étape d'effacement du procédé de programmation de la figure 2 ;
- la figure 4 est un logigramme d'une étape de détermination d'un seuil de résistance du procédé de programmation de la figure 2 ;
- la figure 5 représente deux courbes de variation du taux d'erreurs de programmation en fonction du nombre de cycles de programmation d'une mémoire résistive programmé selon un procédé de l'art antérieur et selon le procédé de la figure 2.

Les figures ne sont présentées qu'à titre indicatif et nullement limitatif de l'invention.
Pour plus de clarté, les éléments identiques ou similaires sont repérés par des signes de référence identiques sur toutes les figures.

**DESCRIPTION DÉTAILLÉE D'AU MOINS UN MODE DE MISE EN ŒUVRE**

La figure 2 montre un procédé de programmation 200 d'une mémoire résistive non volatile, selon un mode de mise en œuvre de l'invention. La mémoire résistive comporte une pluralité de cellules mémoires résistives disposées en lignes en en colonne de manière à former une matrice. Chaque cellule mémoire comporte une première électrode, une deuxième électrode et une couche d'un matériau diélectrique disposée entre la première électrode et la deuxième électrode.

Les cellules mémoires sont par exemple des cellules mémoires résistives à pont conducteur (CBRAM) ou des cellules mémoires résistives à base d'oxyde (OxRAM).

Les électrodes sont des couches conductrices électriquement et peuvent être formées à partir d'un ou plusieurs matériaux conducteurs tels que le titane, le nitrure de titane, le silicium dopé, le tungstène, le nitrure de tungstène, les siliciures de métal, le platine. Les électrodes présentent une épaisseur de préférence comprise entre 5 nm et 30 nm.

Le matériau diélectrique peut être un oxyde de préférence d'un métal de transition tel que l'oxyde de hafnium, l'oxyde de tantale, l'oxyde de titane, l'oxyde de nickel, l'oxyde de tungstène ou l'oxyde de zinc. Le matériau diélectrique peut également être de l'oxyde de silicium, de l'oxyde d'aluminium, de l'oxyde d'indium ou de l'oxyde de gadolinium. Eventuellement, la couche de matériau diélectrique peut comporter plusieurs sous-couches superposées. La couche de matériau diélectrique présente une épaisseur de préférence comprise entre 3nm et 20nm, et plus préférentiellement encore comprise entre 5nm et 10nm.

Le matériau diélectrique, et de manière plus générale la cellule mémoire, peut basculer de manière réversible entre un état faiblement résistif et un état fortement résistif. Ces deux états de résistance permettent donc à la cellule mémoire de stocker une information binaire.

La cellule mémoire peut être soumise à une opération d'écriture, à une opération d'effacement ou à une opération de lecture. Il s'agit de trois opérations élémentaires sur lesquelles se base le fonctionnement de la cellule mémoire.

L'opération d'écriture est une première opération de programmation de la cellule mémoire au cours de laquelle une tension d'écriture est appliquée entre les électrodes de la cellule mémoire. La tension d'écriture est prévue pour placer la cellule mémoire dans l'état faiblement résistif.

L'opération d'effacement est une deuxième opération de programmation de la cellule mémoire au cours de laquelle une tension d'effacement est appliquée entre les électrodes de la cellule mémoire. La tension d'effacement est prévue pour placer la cellule mémoire dans l'état fortement résistif.

L'opération de lecture consiste à déterminer dans quel état de résistance se trouve la cellule mémoire. Pour ce faire, une tension de lecture est appliquée entre les électrodes de la cellule mémoire de manière à déterminer la valeur de résistance de la cellule mémoire. Ensuite, la valeur de résistance de la cellule mémoire est comparée à un premier seuil de résistance dit « seuil de résistance en lecture ». Si la valeur de résistance de la cellule mémoire est inférieure au seuil de résistance en lecture, la cellule mémoire est considérée comme étant dans l'état faiblement résistif. Au contraire, si la valeur de résistance de la cellule mémoire est supérieure au seuil de résistance en lecture, la cellule mémoire est considérée comme étant dans l'état fortement résistif.

Le procédé de programmation 200 comporte une étape de programmation 210 d'une ou plusieurs cellules mémoires. L'étape de programmation 210 peut être une étape d'écriture 210a, une étape d'effacement 210b ou une combinaison de n'importe quel nombre et dans n'importe quel ordre de ces deux étapes 210a, 210b.

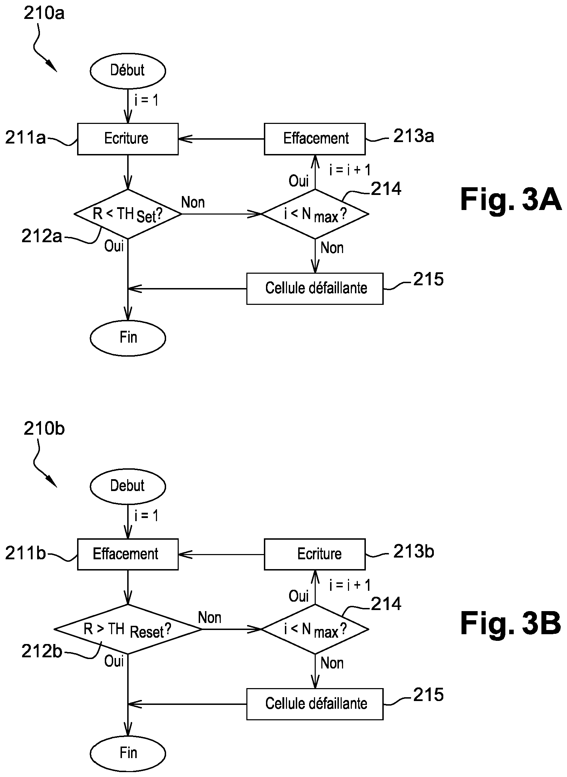

La figure 3A montre un exemple de logigramme de l'étape d'écriture 210a d'une cellule mémoire. L'étape d'écriture 210a comporte une première opération d'écriture 211a de la cellule mémoire. Il s'agit d'une première tentative pour placer la cellule mémoire dans l'état faiblement résistif. Cependant, il n'est pas certain que cette tentative aboutisse au résultat souhaité. En effet, après l'opération d'écriture 211a, il est possible que la cellule mémoire ne soit pas effectivement placée dans l'état faiblement résistif.

L'opération d'écriture 211a est donc suivie par une opération de lecture 212a pour vérifier si la cellule mémoire est effectivement dans l'état faiblement résistif. Il s'agit d'une opération de lecture particulière, appelée « opération de vérification d'écriture », qui est effectuée pendant l'étape d'écriture 210a. Au cours de l'opération de vérification d'écriture 212a, la valeur de résistance R de la cellule mémoire est comparée à un deuxième seuil de résistance dit « seuil de résistance en écriture » $TH_{set}$.

Si la valeur de résistance R de la cellule mémoire est inférieure au seuil de résistance en écriture $TH_{set}$, la cellule mémoire est considérée comme étant dans l'état faiblement résistif, ce qui signifie que l'opération d'écriture 211a a réussi. Dans ce cas, l'étape d'écriture 210a est terminée.

Au contraire, si la valeur de résistance R de la cellule mémoire n'est pas inférieure au seuil de résistance en écriture $TH_{set}$, la cellule mémoire n'est pas considérée comme étant dans l'état faiblement résistif, ce qui signifie que l'opération d'écriture 211a a échoué.

Dans ce dernier cas, on procède avantageusement à une opération d'effacement 213a de la cellule mémoire avant d'effectuer une nouvelle tentative d'écriture 211a de la cellule mémoire. Il est en effet connu qu'en effectuant un cycle complet de programmation, c'est-à-dire une opération d'écriture et une opération d'effacement, on augmente la probabilité d'atteindre l'état de résistance souhaité, en l'occurrence l'état faiblement résistif.

La figure 3B montre un exemple de logigramme de l'étape d'effacement 210b d'une cellule mémoire. Le déroulement de l'étape d'effacement 210b est similaire à celui de de l'étape d'écriture 210a. L'étape d'effacement 210b comporte une première opération d'effacement 211b de la cellule mémoire. Il s'agit d'une première tentative pour placer la cellule mémoire dans l'état fortement résistif. Cependant, il n'est pas certain que cette tentative aboutisse au résultat souhaité. En effet, après l'opération d'effacement 211b, il est possible que la cellule mémoire ne soit pas effectivement placée dans l'état fortement résistif.

L'opération d'effacement 211b est donc suivie par une opération de lecture 212b pour vérifier si la cellule mémoire est effectivement dans l'état fortement résistif. Il s'agit d'une opération de lecture particulière, appelée « opération de vérification d'effacement », qui est effectuée pendant l'étape d'effacement 210b. Au cours de l'opération de vérification d'effacement 212b, la valeur de résistance R de la cellule mémoire est comparée à un troisième seuil de résistance dit « seuil de résistance en effacement » $TH_{Reset}$.

Si la valeur de résistance R de la cellule mémoire est supérieure au seuil de résistance en effacement $TH_{Reset}$, la cellule mémoire est considérée comme étant dans l'état fortement résistif, ce qui signifie que l'opération d'effacement 211b a réussi. Dans ce cas, l'étape d'effacement 210b est terminée.

Au contraire, si la valeur de résistance R de la cellule mémoire n'est pas supérieure au seuil de résistance en effacement $TH_{Reset}$, la cellule mémoire n'est pas considérée comme étant dans l'état fortement résistif, ce qui signifie que l'opération d'effacement 211b a échoué.

Dans ce dernier cas, on procède avantageusement à une opération d'écriture 213b de la cellule mémoire avant d'effectuer une nouvelle tentative d'effacement 211b de la cellule mémoire. On procède ainsi pour la même raison que dans l'étape d'écriture 201 a, c'est-à-dire pour augmenter la probabilité d'atteindre l'état de résistance souhaité, en l'occurrence l'état fortement résistif.

Avantageusement, l'étape de programmation 210, que ce soit une étape d'écriture 210a ou une étape d'effacement 210b, comporte également une étape de comparaison 214 entre le nombre i de tentatives déjà effectuées pour programmer la cellule mémoire et un nombre maximal $N_{max}$ de tentatives prédéterminé. L'étape de comparaison 214 est par exemple effectuée entre chaque tentative de programmation 211a, 211b et l'opération de programmation opposée 213a, 231b correspondante. Le nombre maximal $N_{max}$ de tentatives est par exemple égal à 5.

Si le nombre i de tentatives effectuées est strictement inférieur au nombre maximal $N_{max}$ de tentatives ($i < N_{max}$), le nombre i de tentatives effectuées est incrémenté et l'étape de programmation 210 se poursuit. Dans le cas contraire, la cellule mémoire est déclarée défaillante au cours d'une étape 215 et l'étape de programmation 210 prend fin. L'étape de programmation 210 peut alors être recommencée sur une autre cellule mémoire.

Dans le mode de mise en œuvre illustré à la figure 2, les seuils de résistance en lecture, en écriture et en effacement sont identiques et sont indifféremment désignés par « seuil de référence » dans la suite de la description.

Le procédé de programmation 200 comporte avantageusement une étape d'initialisation 290 de la mémoire résistive. Après leur fabrication, les cellules mémoires sont dans un état vierge caractérisé par une résistance élevée. Les cellules mémoires sont donc initialement dans l'état fortement résistif. Au cours de l'étape d'initialisation 290, la zone de commutation des cellules mémoires est formée pour la première fois, les cellules mémoires basculant alors dans l'état faiblement résistif. Pour ce faire, une tension de formation, également appelée « forming voltage » selon la terminologie anglosaxonne, est appliquée entre les électrodes des cellules mémoires. La tension de formation est supérieure à la tension d'écriture. Les cellules mémoires peuvent ensuite entrer dans un mode de fonctionnement normal dans lequel la tension d'écriture et la tension d'effacement sont utilisées pour faire basculer l'état de résistance.

Avantageusement, l'étape d'initialisation 290 comporte également une phase de conditionnement des cellules mémoires permettant de stabiliser la zone de commutation. La phase de conditionnement consiste par exemple à répéter un certain nombre de cycles de programmation comprenant chacun une opération d'écriture et une opération d'effacement, ces cycles de programmation étant effectués sur l'ensemble des cellules mémoires. La phase de conditionnement comporte par exemple une centaine de cycles de programmation.

Le procédé de programmation 200 comporte également une étape de détermination 230 du seuil de résistance optimal $TH_{opt}$ pour minimiser les erreurs de programmation, c'est-à-dire minimiser le nombre de tentatives nécessaires pour programmer correctement les cellules mémoires. Le temps de programmation est ainsi réduit. Cela revient également à minimiser le nombre de cellules mémoires déclarées défaillantes au cours de l'étape de programmation 210.

L'étape de détermination 230 du seuil de résistance est répétée régulièrement pour ajuster le seuil de résistance en fonction du vieillissement de la mémoire résistive. Un intervalle de temps entre chaque itération de l'étape de détermination 230 est donc défini. Cet intervalle de temps correspond par exemple à un nombre prédéterminé $N_C$ de cycles de programmation. Autrement dit, lorsqu'au moins une cellule mémoire a été programmée ce nombre $N_C$ de fois, l'étape de détermination 230 du seuil de résistance est à nouveau déclenchée. Ce nombre $N_C$ peut dépendre de la technologie des cellules mémoires. Par exemple, pour une cellule mémoire dont le matériau diélectrique est de l'oxyde de hafnium ($HfO_2$) disposé entre deux électrodes en nitrure de titane (TiN), le nombre de cycles $N_C$ est choisi égal à $10^4$, ce qui correspond au nombre de cycles après lequel la variabilité des valeurs de résistance commence à augmenter.

Dans ce cas, un compteur C est implémenté pour suivre le nombre de fois que les cellules mémoires sont programmées. Le procédé de programmation 200 comporte alors une étape de comparaison 250 entre le compteur C et le nombre prédéterminé Ne de cycles de programmation, tel qu'illustré à la figure 2. Le procédé de programmation 200 comporte en outre une étape de remise à zéro 270 du compteur C effectuée après l'étape de détermination 230 du seuil de résistance.

Dans une variante de mise en œuvre, l'intervalle de temps entre deux itérations successives de l'étape de détermination 230 peut diminuer pendant la durée de vie de la mémoire résistive. En d'autres termes, au fur et à mesure du vieillissement de la mémoire résistive, l'étape de détermination 230 est effectuée de plus en plus souvent.

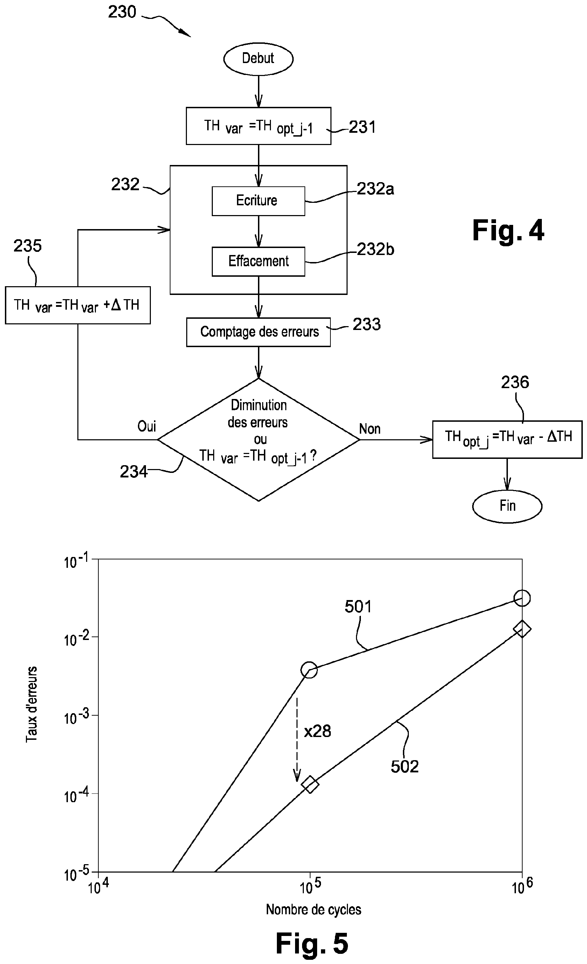

La figure 4 montre un exemple de logigramme de l'étape de détermination 230 du seuil de résistance optimal $TH_{opt\_j}$ au cours d'une itération j.

L'étape de détermination 230 comporte une première étape 231 au cours de laquelle un seuil de résistance variable $TH_{var}$ est défini égal au seuil de résistance optimal $TH_{opt\_j-1}$ déterminé lors de la précédente itération de l'étape de détermination 230. Avantageusement, un seuil de résistance optimal initial THo peut être prédéterminé. Ce dernier peut dépendre de la technologie des cellules mémoires et est obtenu par exemple en caractérisant les cellules mémoires.

On procède ensuite à une étape de programmation spécifique 232 comprenant une première étape d'écriture 232a d'un premier groupe de cellules mémoires et une deuxième étape d'effacement 232b d'un deuxième groupe de cellules mémoire. Avantageusement, dans l'étape de programmation spécifique 232, les cellules mémoires sont programmées en procédant de manière similaire à ce qui est fait dans l'étape de programmation 210 décrite en référence aux figures 3A et 3B. Cependant, dans ce cas, la valeur de résistance des cellules mémoires est comparée au seuil de résistance variable $TH_{var}$.

L'étape de détermination 230 comporte également une étape de comptage 233 du nombre total d'erreurs de programmation survenues lors de l'étape de programmation spécifique 232, c'est-à-dire du nombre de cellules mémoires qui n'ont pas été placées dans l'état de résistance approprié. En l'occurrence, cela revient à compter le nombre de cellules mémoires déclarées défaillantes au cours de l'étape de programmation spécifique 232.

Ensuite, au cours d'une quatrième étape 234, on examine si le seuil de résistance variable $TH_{var}$ est toujours égal au seuil de résistance optimal $TH_{opt\_j-1}$. Si tel est le cas, cela signifie que l'étape de programmation spécifique 232 qui vient d'être effectuée est la première. Dans ce cas, on procède au moins à une deuxième étape de programmation spécifique 232 après avoir modifié le seuil de résistance variable $TH_{var}$ au cours d'une cinquième étape 235.

Le sens de variation du seuil de résistance variable dépend de la technologie des cellules mémoires et peut donc être prédéterminé. Par exemple, pour des cellules mémoires dont les électrodes sont en nitrure de titane (TiN) et le matériau diélectrique est en oxyde d'Hafnium (HfO$_2$), le seuil de résistance optimal TH$_{opt}$ augmente avec le vieillissement des cellules mémoires. Dans ce cas, le seuil de résistance variable TH$_{var}$ est incrémenté d'un pas de résistance ΔTH prédéfini.

Au cours de la quatrième étape 234, on examine également si le nombre d'erreurs de programmation survenues au cours de la dernière étape de programmation spécifique 232 a diminué par rapport au nombre d'erreurs de programmation survenues au cours de la précédente étape de programmation spécifique 232. Si tel est le cas, cela signifie que le seuil de résistance variable TH$_{var}$ n'est pas le seuil de résistance optimal TH$_{opt\_j}$. Dans ce cas, le seuil de résistance variable TH$_{var}$ est à nouveau modifié et une nouvelle étape de programmation spécifique 232 est effectuée.

Si aucune des deux conditions énoncées précédemment n'est vérifiée, c'est-à-dire si le seuil de résistance variable TH$_{var}$ est différent du seuil de résistance optimal TH$_{opt\_j-1}$ et si le nombre d'erreurs de programmation n'a pas diminué, cela signifie que le seuil de résistance variable TH$_{var}$ lors de la précédente étape de programmation spécifique 232 était le seuil de résistance optimal TH$_{opt\_j}$. Dans ce cas, au cours d'une sixième étape 236, le seuil de résistance optimal TH$_{opt\_j}$ est défini égal au seuil de résistance variable TH$_{var}$ actuel auquel on soustrait le pas de résistance ΔTH.

Le premier groupe de cellules mémoires et le deuxième groupe de cellules mémoires comprennent chacun un nombre de cellules mémoires suffisant pour permettre de déterminer correctement le seuil de résistance optimal TH$_{opt}$. Autrement dit, les premier et deuxième groupes sont définies de manière à former chacun un échantillon représentatif du comportement de l'ensemble des cellules mémoires. A titre d'exemple, pour chaque ensemble de 10$^6$ cellules mémoires, chaque groupe peut comporter 4.10$^3$ cellules mémoires. Le premier groupe et le deuxième groupe peuvent être formés par les mêmes cellules mémoires.

La figure 5 montre deux courbes 501, 502 représentant la variation du taux d'erreurs de programmation en fonction du nombre de cycles de programmation d'une mémoire résistive de type TiN/HfO$_2$/TiN. La première courbe 501 correspond à un procédé de programmation de l'art antérieur dans lequel les seuils de résistance en lecture, en écriture et en effacement sont fixes et sont respectivement égales à 12 kΩ, 10 kΩ et 14 KΩ. La deuxième courbe 502 correspond au procédé de programmation de l'invention. Dans ce cas, on utilise un unique seuil de résistance initialement égal à 12 KΩ et qui est ensuite ajuster périodiquement. Dans cet exemple, le pas de résistance ΔTH est égal à 2 KΩ et le seuil de résistance augmente jusqu'à atteindre 36 KΩ. On constate que l'invention permet bien de réduire le taux d'erreurs, ici jusqu'à un facteur 28.

Dans une variante de mise en œuvre, le seuil de résistance optimal TH$_{opt}$ déterminé au cours de l'étape de détermination 230 peut être le seuil de résistance en lecture TH$_{Read}$. Dans ce cas, le seuil de résistance en écriture TH$_{set}$ et le seuil de résistance en effacement TH$_{Reset}$ peuvent être définis par rapport au seuil de résistance en lecture TH$_{Read}$ tels que :

$$TH_{Set} < TH_{Read} < TH_{Reset}$$

Un avantage est de s'assurer une plus grande fenêtre de programmation, c'est-à-dire un écart plus important entre l'état faiblement résistif et l'état fortement résistif. Autrement dit, les conditions sur la valeur de résistance appliquées au cours de la programmation sont plus sévères. Ainsi, il est possible de compenser la dérive dans le temps de la valeur de résistance pour que la cellule mémoire reste dans le bon état de programmation lors de l'opération de lecture. Par exemple, le seuil de résistance en écriture TH$_{set}$ et le seuil de résistance en effacement TH$_{Reset}$ sont respectivement définis égaux à 90 % et à 110 % du seuil de résistance en lecture TH$_{Read}$.

Naturellement, l'invention n'est pas limitée aux modes de mise en œuvre décrits en référence aux figures et des variantes pourraient être envisagées sans sortir du cadre de l'invention.

**Revendications**

1. Procédé de programmation (200) d'une mémoire résistive non volatile comprenant une pluralité de cellules mémoires résistives non volatiles, chaque cellule mémoire étant apte à commuter de manière réversible entre :

   - un premier état de programmation, dit « état faiblement résistif », dans lequel la cellule mémoire a une valeur de résistance électrique (R) inférieure à un premier seuil de résistance (TH$_{opt}$) ; et
   - un deuxième état de programmation, dit « état fortement résistif », dans lequel la cellule mémoire a une valeur de résistance électrique (R) supérieure au premier seuil de résistance (TH$_{opt}$) ;

   le procédé de programmation (200) étant **caractérisé en ce qu'**il comporte une étape de détermination (230) du premier seuil de résistance (TH$_{opt}$) effectuée périodiquement, l'étape de détermination (230) comprenant :

   - une première étape d'écriture (232a) destinée à placer un premier groupe de cellules mémoires dans l'état faiblement résistif, un premier nombre de cellules mémoires du premier groupe n'étant pas effectivement placées dans l'état faiblement résistif après la première étape de programmation ; et

- une deuxième étape d'effacement (232b) destinée à placer un deuxième groupe de cellules mémoires dans l'état fortement résistif, un deuxième nombre de cellules mémoires du deuxième groupe n'étant pas effectivement placées dans l'état fortement résistif après la deuxième étape de programmation ;

le premier seuil de résistance ($TH_{opt}$) étant déterminé de manière à minimiser un nombre d'erreurs de programmation égal à la somme du premier nombre de cellules mémoires et du deuxième nombre de cellules mémoires.

2. Procédé de programmation (200) selon la revendication 1, **caractérisé en ce que** l'étape de détermination (230) du premier seuil de résistance ($TH_{opt}$) comporte les étapes suivantes :

    a) définir (231) un seuil de résistance variable ($TH_{var}$) égal au premier seuil de résistance ($TH_{opt}$) déterminé au cours de la précédente étape de détermination (230) ;
    b) effectuer la première étape d'écriture (232a) et la deuxième étape d'effacement (232) en utilisant le seuil de résistance variable ($TH_{var}$) ;
    c) déterminer (233) le nombre d'erreurs de programmation survenues au cours de l'étape b) ;
    d) répéter les étapes b) et c) après avoir modifié (235) le seuil de résistance variable selon un sens de variation prédéterminé, les étapes b) et c) étant répétées au moins une fois et tant que le nombre d'erreurs de programmation diminue entre deux étapes b) consécutives ;
    e) définir (236) le premier seuil de résistance ($TH_{opt}$) égal au seuil de résistance variable ($TH_{var}$) utilisé au cours de l'avant-dernière étape b).

3. Procédé de programmation (200) selon l'une quelconque des revendications 1 et 2, **caractérisé en ce que** deux étapes consécutives de détermination (230) du premier seuil de résistance ($TH_{opt}$) sont séparées par un intervalle de temps correspondant à un premier nombre prédéterminé ($N_C$) de cycles de programmation qu'au moins une cellule mémoire a subi.

4. Procédé de programmation (200) selon l'une quelconque des revendications 1 à 3, **caractérisé en ce qu'**il comporte une étape de programmation (210) comprenant au moins l'une des étapes suivantes :

- une étape d'écriture (210a) destinée à placer au moins une cellule mémoire dans l'état faiblement résistif, ladite au moins une cellule mémoire étant considérée comme étant dans l'état faiblement résistif au terme de l'étape d'écriture (210a) si la valeur de résistance (R) de ladite au moins une cellule mémoire est inférieure à un deuxième seuil de résistance ($TH_{set}$) inférieur ou égal au premier seuil de résistance ($TH_{opt}$) ;
- une étape d'effacement (210b) destinée à placer au moins une cellule mémoire dans l'état fortement résistif, ladite au moins une cellule mémoire étant considérée comme étant dans l'état fortement résistif au terme de l'étape d'effacement (210b) si la valeur de résistance (R) de ladite au moins une cellule mémoire est supérieure à un troisième seuil de résistance ($TH_{Reset}$) supérieur ou égal au premier seuil de résistance ($TH_{opt}$) ;

le deuxième seuil de résistance ($TH_{set}$) et le troisième seuil de résistance ($TH_{Reset}$) étant définis en fonction du premier seuil de résistance déterminé.

5. Procédé de programmation (200) selon la revendication 4, **caractérisé en ce que** le deuxième seuil de résistance ($TH_{set}$) et le troisième seuil de résistance ($TH_{Reset}$) sont égaux au premier seuil de résistance ($TH_{opt}$).

6. Procédé de programmation (200) selon la revendication 4, **caractérisé en ce que** le deuxième seuil de résistance ($TH_{set}$) et le troisième seuil de résistance ($TH_{Reset}$) sont respectivement égaux à 90 % et à 110 % du premier seuil de résistance ($TH_{opt}$).

7. Procédé de programmation (200) selon l'une quelconque des revendications 1 à 6, **caractérisé en ce que** chaque cellule mémoire comporte un matériau diélectrique disposé entre deux électrodes, la cellule mémoire passant de l'état fortement résistif à l'état faiblement résistif lorsqu'une zone de commutation est formée dans le matériau diélectrique, la zone de commutation reliant électriquement les électrodes de la cellule mémoire, le procédé de programmation (200) comportant en outre une étape d'initialisation (290) de la mémoire résistive comprenant les étapes suivantes :

- former pour la première fois la zone de commutation de chaque cellule mémoire ; et
- conditionner les cellules mémoires en répétant un deuxième nombre prédéterminé de cycles de programmation comprenant chacun une opération d'écriture et une opération d'effacement des cellules mémoires.

8. Procédé de programmation (200) selon l'une quelconque des revendications 1 à 7, **caractérisé en ce que** les cellules mémoires sont de type CBRAM ou OxRAM.

## Patentansprüche

1. Programmierverfahren (200) eines nicht flüchtigen, resistiven Speichers (200), umfassend eine Vielzahl von nicht flüchtigen, resistiven Speicherzellen, wobei jede Speicherzelle geeignet ist, reversibel umzuschalten zwischen:

 - einem ersten Programmierzustand, bezeichnet als "schwach resistiver Zustand", bei dem die Speicherzelle einen elektrischen Widerstandswert (R) aufweist, der niedriger ist als ein erster Widerstandsschwellenwert ($TH_{opt}$); und;
 - einem zweiten Programmierzustand, bezeichnet als "stark resistiver Zustand", bei dem die Speicherzelle einen elektrischen Widerstandswert (R) aufweist, der höher ist als der erste Widerstandsschwellenwert ($TH_{opt}$);

 wobei das Programmierverfahren (200) **dadurch gekennzeichnet ist, dass** es einen Bestimmungsschritt (230) des ersten Widerstandsschwellenwertes ($TH_{opt}$) umfasst, der periodisch durchgeführt wird, wobei das Bestimmungsverfahren (230) umfasst:

 - einen ersten Schreibschritt (232a), der zum Platzieren einer ersten Gruppe von Speicherzellen in den schwach resistiven Zustand bestimmt ist, wobei eine erste Anzahl von Speicherzellen der ersten Gruppe nach dem ersten Programmierschritt nicht effektiv in den schwach resistiven Zustand platziert wird; und
 - einen zweiten Löschschritt (232b), der zum Platzieren einer zweiten Gruppe von Speicherzellen in dem stark resistiven Zustand bestimmt ist, wobei eine zweite Anzahl von Speicherzellen der zweiten Gruppe nach dem zweiten Programmierschritt nicht effektiv in den stark resistiven Zustand platziert wird;

 wobei der erste Widerstandsschwellenwert ($TH_{opt}$) derart bestimmt wird, dass eine Anzahl von Programmierfehlern minimiert wird, die gleich der Summe der ersten Anzahl von Speicherzellen und der zweiten Anzahl von Speicherzellen ist.

2. Programmierverfahren (200) gemäß Anspruch 1, **dadurch gekennzeichnet, dass** der Bestimmungsschritt (230) des ersten Widerstandsschwellenwertes ($TH_{opt}$) die folgenden Schritte umfasst:

 a) Definieren (231) eines variablen Widerstandsschwellenwertes ($TH_{var}$) gleich dem ersten Widerstandsschwellenwert ($TH_{opt}$), der im Verlauf des vorherigen Bestimmungsschritts (230) bestimmt wird;
 b) Durchführen des ersten Schreibschritts (232a) und des zweiten Löschschritts (232) unter Verwenden des variablen Widerstandsschwellenwertes ($TH_{var}$);
 c) Bestimmen (233) der Anzahl von Programmierfehlern, die im Verlauf des Schritts b) aufgetreten sind;
 d) Wiederholen der Schritte b) und c) nach dem Modifizieren (235) des variablen Widerstandsschwellenwertes gemäß einer vorbestimmten Variationsrichtung, wobei die Schritte b) und c) wenigstens ein Mal wiederholt werden und solange die Anzahl von Programmierfehlern zwischen zwei aufeinanderfolgenden Schritten b) abnimmt;
 e) Definieren (236) des ersten Widerstandsschwellenwertes ($TH_{opt}$) gleich dem variablen Widerstandsschwellenwert ($TH_{var}$), der im Verlauf des vorletzten Schritts b) verwendet wird.

3. Programmierverfahren (200) gemäß irgendeinem der Ansprüche 1 und 2, **dadurch gekennzeichnet, dass** zwei aufeinanderfolgende Bestimmungsschritte (230) des ersten Widerstandsschwellenwertes ($TH_{opt}$) durch ein Zeitintervall getrennt werden, das einer ersten vorbestimmten Anzahl (Nc) von Programmierschritten entspricht, dem wenigstens eine Speicherzelle unterzogen worden ist.

4. Programmierverfahren (200) gemäß irgendeinem der Ansprüche 1 bis 3, **dadurch gekennzeichnet, dass** es einen Programmierschritt (210) umfasst, umfassend wenigstens einen der folgenden Schritte:

 - einen Schreibschritt (210a), der zum Platzieren wenigstens einer Speicherzelle in den schwach resistiven Zustand bestimmt ist, wobei die genannte wenigstens eine Speicherzelle nach Abschluss des Schreibschritts (210a) als in dem schwach resistiven Zustand befindlich betrachtet wird, wenn der Widerstandswert (R) der genannten wenigstens einen Speicherzelle niedriger ist als ein zweiter Widerstandsschwellenwert ($TH_{set}$), der niedriger als oder gleich dem ersten Widerstandsschwellenwert ($TH_{opt}$) ist;
 - einen Löschschritt (210b), der zum Platzieren wenigstens einer Speicherzelle in den stark resistiven Zustand bestimmt ist, wobei die genannte wenigstens eine Speicherzelle nach Abschluss des Löschschritts (210b) als im stark resistiven Zustand befindlich betrachtet wird, wenn der Widerstandswert (R) der genannten wenigstens einen Speicherzelle höher ist als ein dritter Widerstandsschwellernt ($TH_{Reset}$), der höher als oder gleich dem ersten Widerstandsschwellenwert ($TH_{opt}$) ist;

wobei der zweite Widerstandsschwellernwert ($TH_{set}$) und der dritte Widerstandsschwellenwert ($TH_{Reset}$) in Abhängigkeit von dem bestimmten ersten Widerstandsschwellenwert definiert sind.

5. Programmierverfahren (200) gemäß Anspruch 4, **dadurch gekennzeichnet, dass** der zweite Widerstandsschwellenwert ($TH_{set}$) und der dritte Widerstandsschwellenwert ($TH_{Reset}$) gleich dem ersten Widerstandsschwellenwert ($TH_{opt}$) sind.

6. Programmierverfahren (200) gemäß Anspruch 4, **dadurch gekennzeichnet, dass** der zweite Widerstandsschwellenwert ($TH_{set}$) und der dritte Widerstandsschwellenwert ($TH_{Reset}$) jeweils gleich 90 % und 110 % des ersten Widerstandsschwellenwertes ($TH_{opt}$) sind.

7. Programmierverfahren (200) gemäß irgendeinem der Ansprüche 1 bis 6, **dadurch gekennzeichnet, dass** jede Speicherzelle ein dielektrisches Material umfasst, das zwischen zwei Elektroden angeordnet ist, wobei die Speicherzelle vom stark resistiven Zustand in den schwach resistiven Zustand übergeht, wenn in dem dielektrischen Material ein Umschaltbereich gebildet wird, wobei der Umschaltbereich die Elektroden der Speicherzelle elektrisch verbindet, wobei das Programmierverfahren (200) darüber hinaus einen Initialisierungsschritt (290) des resistiven Speichers umfasst, umfassend die folgenden Schritte:

   - Bilden des Umschaltbereichs jeder Speicherzelle zum ersten Mal; und
   - Aufbereiten der Speicherzellen durch Wiederholen einer zweiten vorbestimmten Anzahl von Programmierzyklen, die jeweils eine Schreiboperation und eine Löschoperation der Speicherzellen umfassen.

8. Programmierverfahren (200) gemäß irgendeinem der Ansprüche 1 bis 7, **dadurch gekennzeichnet, dass** die Speicherzellen vom Typ CBRAM oder Ox-RAM sind.

## Claims

1. Method for programming (200) a non-volatile resistive memory comprising a plurality of non-volatile resistive memory cells, each memory cell being able to switch in a reversible manner between:

   - a first programming state, called "low resistance state", in which the memory cell has an electrical resistance value (R) lower than a first resistance threshold ($TH_{opt}$); and
   - a second programming state, called "high resistance state", in which the memory cell has an electrical resistance value (R) greater than the first resistance threshold ($TH_{opt}$);

   the programming method (200) being **characterised in that** it comprises a step of determining (230) the first resistance threshold ($TH_{opt}$) carried out periodically, the determination step (230) comprising:

   - a first writing step (232a) intended to place a first group of memory cells in the low resistance state, a first number of memory cells of the first group not actually being placed in the low resistance state after the first programming step; and
   - a second erasing step (232b) intended to place a second group of memory cells in the high resistance state, a second number of memory cells of the second group not actually being placed in the high resistance state after the second programming step;

   the first resistance threshold ($TH_{opt}$) being determined so as to minimise a number of programming errors equal to the sum of the first number of memory cells and the second number of memory cells.

2. Programming method (200) according to claim 1, **characterised in that** the step of determining (230) the first resistance threshold ($TH_{opt}$) comprises the following steps:

   a) defining (231) a variable resistance threshold ($TH_{var}$) equal to the first resistance threshold ($TH_{opt}$) determined during the preceding determination step (230);
   b) carrying out the first writing step (232a) and the second erasing step (232) using the variable resistance threshold ($TH_{var}$);
   c) determining (233) the number of programming errors arising during step b);
   d) repeating steps b) and c) after having modified (235) the variable resistance threshold according to a predetermined sense of variation, steps b) and c) being repeated at least once and as long as the number of programming errors decreases between two consecutive steps b);
   e) defining (236) the first resistance threshold ($TH_{opt}$) equal to the variable resistance threshold ($TH_{var}$) used during the penultimate step b).

3. Programming method (200) according to any of claims 1 and 2, **characterised in that** two consecutive steps of determining (230) the first resistance threshold ($TH_{opt}$) are separated by a time interval corresponding to a first predetermined number (Nc) of programming cycles that at least one memory cell has undergone.

4. Programming method (200) according to any of claims 1 to 3, **characterised in that** it comprises a programming step (210) comprising at least one of the following steps:

- a writing step (210a) intended to place at least one memory cell in the low resistance state, said at least one memory cell being considered as being in the low resistance state at the end of the writing step (210a) if the resistance value (R) of said at least one memory cell is lower than a second resistance threshold ($TH_{Set}$) lower than or equal to the first resistance threshold ($TH_{opt}$);
- an erasing step (210b) intended to place at least one memory cell in the high resistance state, said at least one memory cell being considered as being in the high resistance state at the end of the erasing step (210b) if the resistance value (R) of said at least one memory cell is greater than a third resistance threshold ($TH_{Reset}$) greater than or equal to the first resistance threshold ($TH_{opt}$);

the second resistance threshold ($TH_{set}$) and the third resistance threshold ($TH_{Reset}$) being defined as a function of the determined first resistance threshold.

5. Programming method (200) according to claim 4, **characterised in that** the second resistance threshold ($TH_{set}$) and the third resistance threshold ($TH_{Reset}$) are equal to the first resistance threshold ($TH_{opt}$).

6. Programming method (200) according to claim 4, **characterised in that** the second resistance threshold ($TH_{set}$) and the third resistance threshold ($TH_{Reset}$) are respectively equal to 90 % and to 110 % of the first resistance threshold ($TH_{opt}$).

7. Programming method (200) according to any of claims 1 to 6, **characterised in that** each memory cell comprises a dielectric material arranged between two electrodes, the memory cell passing from the high resistance state to the low resistance state when a switching zone is formed in the dielectric material, the switching zone electrically connecting the electrodes of the memory cell, the programming method (200) further comprising a step of initialisation (290) of the resistive memory comprising the following steps:

- forming for the first time the switching zone of each memory cell; and
- conditioning the memory cells by repeating a second predetermined number of programming cycles each comprising an operation of writing and an operation of erasing the memory cells.

8. Programming method (200) according to any of claims 1 to 7, **characterised in that** the memory cells are of CBRAM or OxRAM type.

Nombre
de cellules

101

102

Résistance

# Fig. 1

200

Initialisation — 290

Détermination TH$_{opt}$ — 230

C = 0 — 270

210

Programmation (C ++)

NON   C ≤ N$_c$?   OUI

250

# Fig. 2

**Fig. 3A**

**Fig. 3B**

230

Debut

TH $_{var}$ =TH $_{opt\_j-1}$ —231

232 —

Ecriture —232a

Effacement —232b

**Fig. 4**

235

TH $_{var}$ =TH $_{var}$ +$\Delta$ TH

Comptage des erreurs —233

236

Diminution
des erreurs
ou
TH $_{var}$ =TH $_{opt\_j-1}$ ?

Oui

Non

TH $_{opt\_j}$ =TH $_{var}$ - $\Delta$TH

234—

Fin

$10^{-1}$

$10^{-2}$

501

$10^{-3}$

x28

$10^{-4}$

502

$10^{-5}$

$10^4$

$10^5$

$10^6$

Taux d'erreurs

Nombre de cycles

**Fig. 5**

**EP 3 561 812 B1**

## RÉFÉRENCES CITÉES DANS LA DESCRIPTION

**Documents brevets cités dans la description**

• US 2013258753 A